# EUROPÄISCHE PATENTANMELDUNG

(11) **EP 1 063 873 A2**
(43) Veröffentlichungstag der Anmeldung: **27.12.2000**
(21) Anmeldenummer: 00110025.4
(22) Anmeldetag: 12.05.2000
(51) Int. Cl.: H05K 3/00, H05K 13/00

(54) **Verfahren zum Herstellen von Substraten mit strukturierten Metallisierungen sowie Halte-und Fixierelement zur Verwendung bei dem Verfahren**

(30) Priorität: 22.06.1999 DE 19928401; 30.06.1999 DE 19930207
(71) Anmelder: Schulz-Harder, Jürgen, Dr.-Ing., 91207 Lauf (DE)
(72) Erfinder: Schulz-Harder, Dr.-Ing. Jürgen, 91207 Lauf (DE)
(74) Vertreter: Graf, Helmut, Dipl.-Ing.

(57) **Zusammenfassung**

Die Erfindung bezieht sich auf ein neuartiges Verfahren zum Herstellen von Substraten mit strukturierten Metallisierungen sowie Halte- und Fixierelement zur Verwendung bei diesem Verfahren.

## Beschreibung

Die Erfindung bezieht sich auf ein Verfahren gemäß Oberbegriff Patentanspruch 1 sowie auf ein Halte- und Fixierelement.

Die Herstellung von Substraten mit strukturierten Metallisierungen, die (Substrate) als Leiterplatten für elektrische Haltungen dienen, sind in unterschiedlichsten Ausführungen bekannt. Grundsätzlich erfolgt die Strukturierung beispielsweise unter Anwendung einer Maskierungs- und Ätztechnik.

Die Substrate im Sinne der Erfindung sind beispielsweise Keramik-Metall-Substrate, die im einfachsten Fall aus einer Keramikschicht bestehen, die auf einer Oberflächenseite, bevorzugt aber an beiden Oberflächenseiten mit einer Metallisierung versehen sind, und zwar beispielsweise in Form einer dort flächig aufgebrachten Metallfolie.

Bekannt ist es, diese zum Herstellen von Leiterbahnen, Anschlüssen usw. benötigten Metallisierungen auf der Keramik, z.B. auf der Aluminium-Oxid-Keramik mit Hilfe des sogenannten 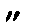 DCB-Verfahrens" (Direct-Copper-Bond-Technology) herzustellen, und zwar unter Verwendung von die jeweilige Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas, bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so daß durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:
- Oxidieren einer Kupferfolie derart, daß sich eine gleichmäßige Kupferoxidschicht ergibt;
- Auflegen des Kupferfolie auf die Keramikschicht;
- Erhitzen des Verbundes auf eine Prozeßtemperatur zwischen etwa 1025 bis 1083°C, z.B. auf ca. 1071°C;
- Abkühlen auf Raumtemperatur.

Die Substrate im Sinne der Erfindung sind aber auch beispielsweise solche, die aus einer Trag- und/oder Isolierschicht aus Kunststoff bestehen, die an wenigstens einer Oberflächenseite mit einer von einer Metallfolie gebildete Metallisierung versehen ist. Die Substrate im Sinne der Erfindung sind auch bekannte Substrate, bei denen auf einer Trägerschicht aus Metall, beispielsweise aus Aluminium eine dünne Isolierschicht, beispielsweise aus Kunststoff aufgebracht ist, die dann die Metallisierung beispielsweise in Form einer Metallfolie trägt.

Aufgabe der Erfindung ist es, ein Verfahren aufzuzeigen, mit der eine Strukturierung in besonders rationeller Weise möglich ist, insbesondere auch mit der bekannten Maskierungs- und Ätztechnik.

Zur Lösung dieser Aufgabe ist ein Verfahren entsprechend dem Patentanspruch 1 ausgebildet. Ein Halte- oder Fixierelement ist entsprechend dem Patentanspruch 10 ausgebildet.

Das erfindungsgemäße Verfahren bietet u.a. den Vorteil, daß in einem Arbeitsprozeß jeweils wenigstens zwei Substrate oder Leiterplatten gleichzeitig strukturiert werden können, und zwar jeweils nur an einer Oberflächenseite, wobei die andere Oberflächenseite bzw. eine dort vorhandene Metallisierung nicht beeinträchtigt wird.

Die Erfindung bietet auch den Vorteil, daß eine nur einseitige Strukturierung von Leiterplatten bzw. Substraten mit den üblicherweise für eine beidseitige Strukturierung vorhandenen Betriebsmitteln möglich ist, so daß dieselben Betriebsmittel für eine nur einseitige oder eine beidseitige Strukturierung eingesetzt werden können.

Weiterbildungen der Erfindung sind Gegenstand der Unteransprüche. Die Erfindung wird im Folgenden anhand der Figuren an Ausführungsbeispielen näher erläutert. Es zeigen:
- Fig. 1: in vereinfachter Darstellung und im Teilschnitt zwei zu strukturierende Substrate, zusammen mit einem Halte- oder Fixierelement;
- Fig. 2: eine Darstellung ähnlich Figur 1, jedoch bei über das Halte- oder Fixierelement dicht miteinander verbundenen Substraten;
- Fig. 3: in schematischer Darstellung eine Draufsicht auf die Anordnung der Figur 2;
- Fig. 4 - 6: verschiedene weitere Schritte des Verfahrens zum gleichzeitigen Strukturieren der beiden über das Halte- oder Fixierelement miteinander verbundenen Substrate;
- Fig. 7: in vergrößerter Teildarstellung einen Schnitt durch das Fixier- oder Halteelement zur Verwendung bei dem Verfahren;
- Fig. 8: in vereinfachter Teildarstellung das Halte- oder Fixierelement der Figur 7 in Draufsicht;
- Fig. 9: in einer Darstellung ähnlich Figur 7 eine weitere mögliche Ausführungsform des Halte- oder Fixierelementes;
- Fig. 10: in Teildarstellung und in Draufsicht das Halte- und Fixierelement der Figur 9;
- Fig. 11: zwei zu strukturierende Substrate mit einem vereinfachten Halte- oder Fixierelement gemäß einer weiteren Ausführung der Erfindung;
- Fig. 12: in vereinfachter Darstellung eine Draufsicht auf das Fixierelement der Figur 11;
- Fig. 13: in vereinfachter Darstellung eine Draufsicht auf eine weitere Ausführungsform eines Fixierelementes;
- Fig. 14: einen Schnitt entsprechend der Linie I -I der Figur 13;
- Fig. 15: in einer Darstellung ähnlich Fig. 7 eine weitere mögliche Ausführungsform.

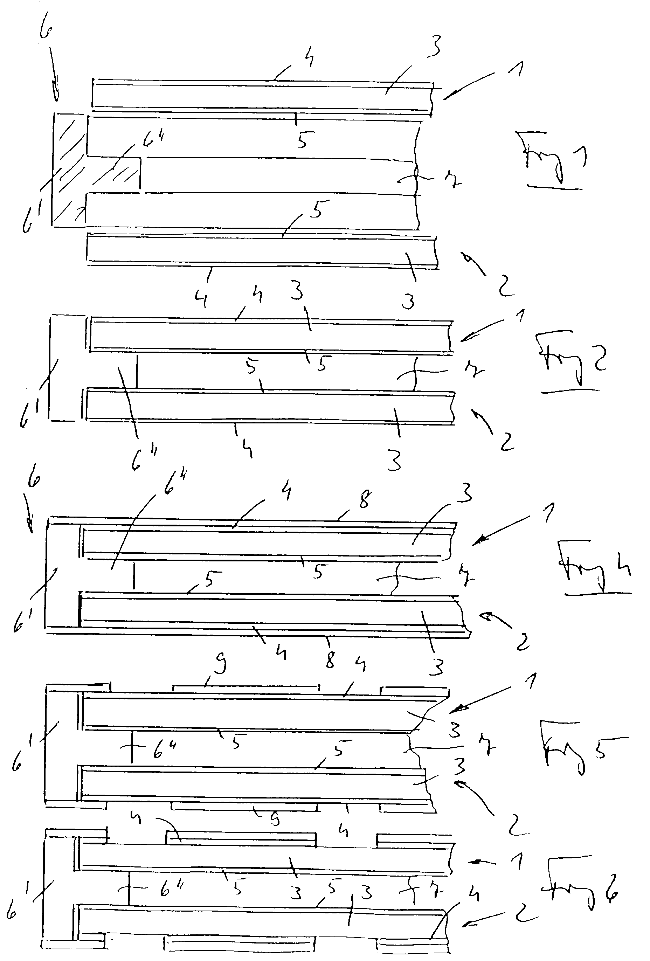

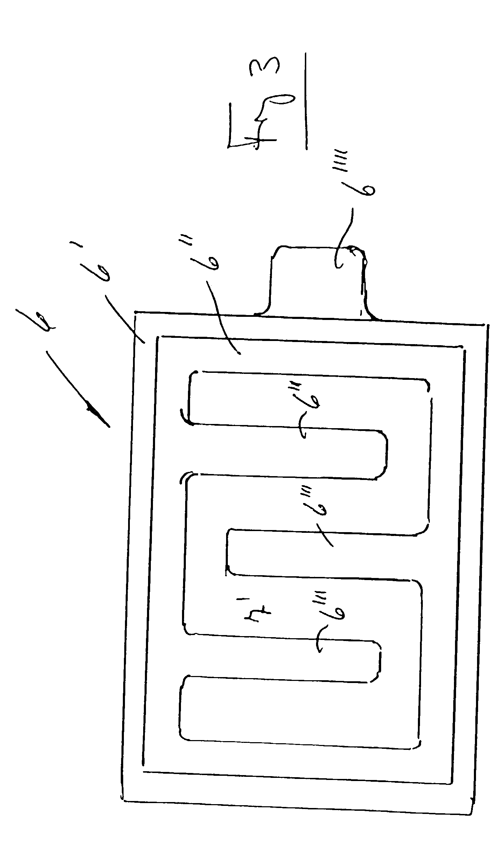

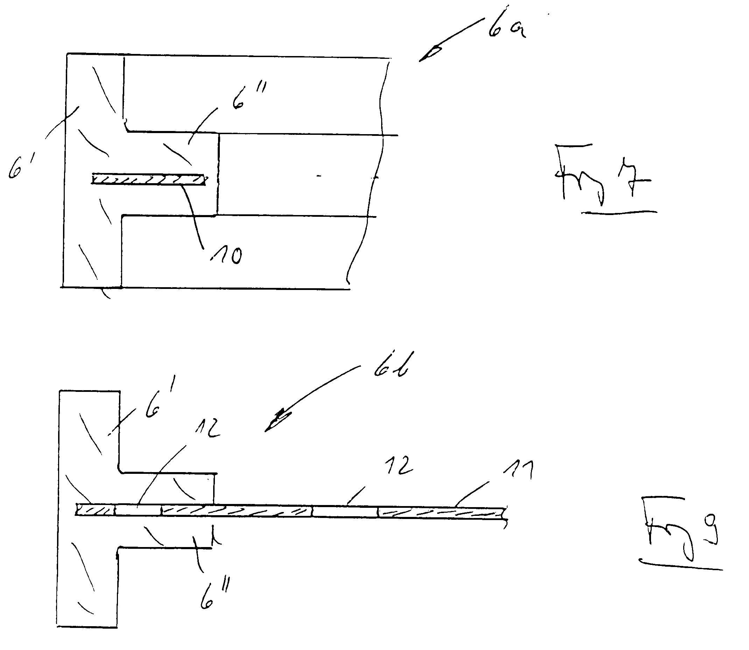

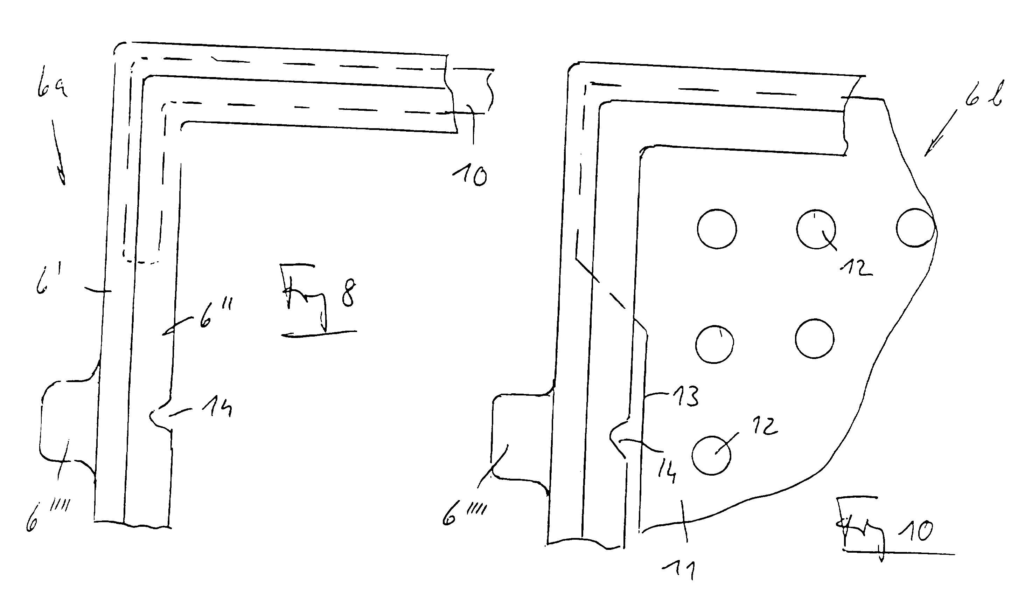

In den Figuren 1 - 6 sind 1 und 2 zwei bei der dargestellten Ausführungsform in Form, Größe und Aufbau identische Substrate, die bei der dargestellten Ausführungsform jeweils aus einer Isolierschicht in Form einer Keramikschicht 3 sowie aus Metallisierungen 4 bzw. 5 an den beiden Oberflächenseiten der Keramikschicht 3 bestehen.

Es ist beabsichtigt, mit dem nachstehend näher beschriebenen Verfahren beide Substrate 1 und 2 gleichzeitig, d.h. in einem Arbeitsgang jeweils an einer Oberflächenseite, d.h. an der Metallisierung 4 zu strukturieren, wobei die jeweilige Metallisierung 5 unberührt bleiben soll. Bei der dargestellten Ausführungsform sind die Metallisierungen 4 und 5 jeweils von Metallfolien- oder platten, beispielsweise von Kupferfolien gebildet, die flächig auf der jeweiligen Oberflächenseite der Keramikschicht 3 befestigt sind, beispielsweise unter Verwendung des DCB-Verfahrens oder eines Aktiv-Löt-Prozesses.

Wie in der Figur 1 dargestellt ist, werden die beiden Substrate 1 und 2 jeweils mit ihrer Metallisierung 5 auf ein Halte- oder Fixierelement 6 aufgelegt. Wie auch in der Figur 3 dargestellt ist, ist dieses Halte- oder Fixierelement als Ring aus einem luft- und gasdichten sowie elastischen Material ausgebildet, und zwar in Draufsicht (Figur 3) in einer Formgebung, die dem Verlauf des Umfangsrandes des jeweiligen Substrates 1 bzw. 2 entspricht, d.h. bei rechteckförmigen Substraten 1 und 2 mit einem rechteckförmigen Verlauf. Wie die Figuren auch zeigen, besitzt das Halte- oder Fixierelement 6 weiterhin ein T-förmiges Querschnittsprofil, welches sich aus einem Profilabschnitt 6', der sich senkrecht zur Ebene des Ringes des Halte- oder Fixierelementes 7 erstreckt und den äußeren Rand dieses Ringes bildet, sowie aus einem Profilabschnitt 6'' zusammensetzt. Letzterer liegt mit seiner Erstreckung in der Ebene des von dem Halte- und Fixierelement 6 gebildeten Ringes und erstreckt sich von der Mitte der Höhe des Profilabschnittes 6' radial nach innen. Der Profilabschnitt 6'' bildet einen ringförmigen Bereich, auf dem die beiden Substrate 1 und 2 mit ihrer Metallisierung 5 am Umfang des Substrates aufliegen. Der Profilabschnitt 6' deckt die Substrate 1 und 2 entlang des Umfangs an der dortigen Umfangsfläche bzw. Stirnseite ab und reicht bei der dargestellten Ausführungsform bei am Halte- und Fixierelement 6 vorgesehenen Substraten 1 und 2 bis an die jeweils außen liegenden Metallisierungen 4.

Wie die Figur 3 zeigt, sind am Profilabschnitt 6'' fingerartige Profilabschnitte 6''' vorgesehen, die in den von dem Halte- und Fixierelement 6 und den Substraten 1 und 2 gebildeten geschlossenen Raumes 7 hineinragen und in Richtung senkrecht zur Ebene des ringförmigen Halte- und Fixierelementes 6 und damit senkrecht zur Ebene der Substrate 1 und 2 die gleiche Dicke wie der Profilabschnitt 6'' aufweisen. Die Profilabschnitte 6''' bilden somit eine zusätzliche Unterstützung der Substrate 1 und 2 innerhalb der Ringöffnung des Halte- oder Fixierelementes 6 und verhindern zu hohe Spannungen in den Substraten durch das Vakuum im Raum 7..

Nach dem Auflegen der Substrate 1 und 2 auf das Halte- oder Fixierelement 6 wird der zwischen den dann beabstandeten Substraten gebildete Raum 7 auf den Unterdruck P evakuiert. Zur Erzeugung des Unterdrucks P im Raum 7 wird die Anordnung bestehend aus den Substraten 1 und 2 in eine Kammer eingebracht, die auf den Unterdruck evakuiert und die dann mehr oder weniger plötzlich, d.h. in einem sehr kurzen Zeitintervall, beispielsweise in einem Zeitintervall kleiner als 10 Sekunden auf Atmosphärendruck Pa belüftet wird, so daß aufgrund der plötzlichen Druckänderung die Substrate 1 und 2 mit ihrem Rand gegen das Fixierelement 6 angepreßt werden und somit praktische keine Belüftung des Raumes 7 zur Atmosphäre hin erfolgt.

Das Vakuum in dem Raum 7 ist so gewählt, daß der dortige Druck P nach dem Evakuieren kleiner ist als 80% des Umgebungsdruckes Pa. Durch das für das Halte- oder Fixierelement 6 verwendeten elastischen Material ist ein dichter Abschluß des Raumes 7 durch das Fixierelement 6 gewährleistet, so daß die Substrate auch bei den weiteren Verfahrensschritten sicher zusammengehalten sind.

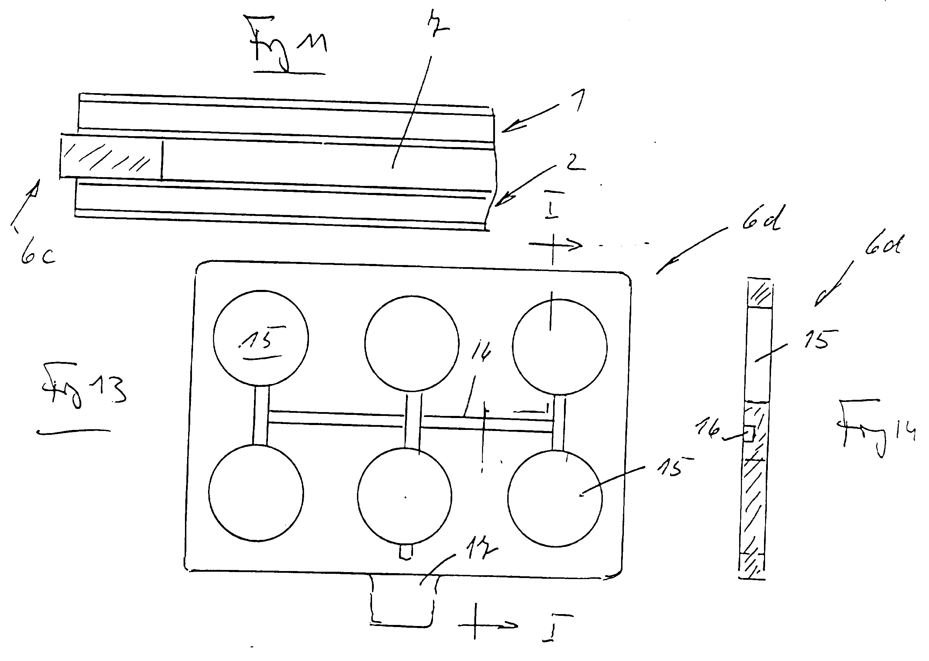

In einem weiteren Verfahrensschritt wird auf die beiden außen und damit freiliegenden Metallisierungen 4 eine Schicht 8 aus einem Fotolack aufgebracht, und zwar beispielsweise durch Eintauchen der Anordnung bestehend aus den beiden Substraten 1 und 2 und dem Fixierelement 6 in den Fotolack. Beide Fotolackschichten 8 werden dann entsprechend der jeweils gewünschten Strukturierung belichtet, und zwar entweder gleichzeitig oder zeitlich nacheinander. Anschließend erfolgt das Entwickeln des belichteten Fotolackes 8 zur Bildung der Masken 9 aus Fotolack aus den Metallisierungen 4 (Figur 5). In einem weiteren Arbeitsschritt erfolgt dann unter Verwendung der Fotolackmasken das beiderseitige Ätzen der Metallisierungen 4 beider Substrate 1 und 2, so daß nach dem Entfernen der Fotolackmasken 9 die beiden, an den Metallisierungen 4 strukturierten Substrate 1 und 2 erhalten sind.

Wie die Figuren weiterhin auch zeigen, wird der Fotolack 8 so aufgebracht, daß er auch den Spalt zwischen dem Umfang des jeweiligen Substrates 1 und 2 und dem dieses Substrat am Rand abdeckenden Teil des Profilabschnittes 6' überdeckt, so daß bei entsprechender Ausbildung der Fotomaske 9 dieser Spalt beim Ätzprozeß gegen Einbringen von Ätzflüssigkeit abgedeckt ist.

Das Trennen der Substrate 1 und 2 von dem Fixierelement 6 erfolgt durch Belüften des Raumes 7, beispielsweise dadurch, daß das elastische Fixierelement 6 an einer Stelle mit einem am Profilabschnitt 6' außen angeformten Profilabschnitt 6'''' gefaßt und nach außen gezogen wird, so daß über die dann sich bildende Öffnung ein Druckausgleich mit der umgebenden Atmosphäre erfolgen kann.

Grundsätzlich kann das Öffnen auch so erfolgen, daß zum Belüften des Raumes 7 die Anordnung aus den Substraten 1 und 2 und dem Fixierelement 6 nochmals in einen Raum eingebracht wird, der auf einen Druck gleich oder in etwa gleich dem Druck P evakuiert und der dann sehr langsam auf den Atmosphärendruck Pa belüftet wird, so daß ohne ein Anpressen der Substrate 1 und 2 gegen das Fixierelement 6 und damit ohne ein Abdichten der Substrate am Fixierelement 6 der Innenraum 7 langsam belüftet wird.

Vorstehend wurde davon ausgegangen, daß die Maske 9 solche aus Fotolack sind. Selbstverstandlich können auch andere Masken aus einem Ätz-Resistive Verwendung finden.

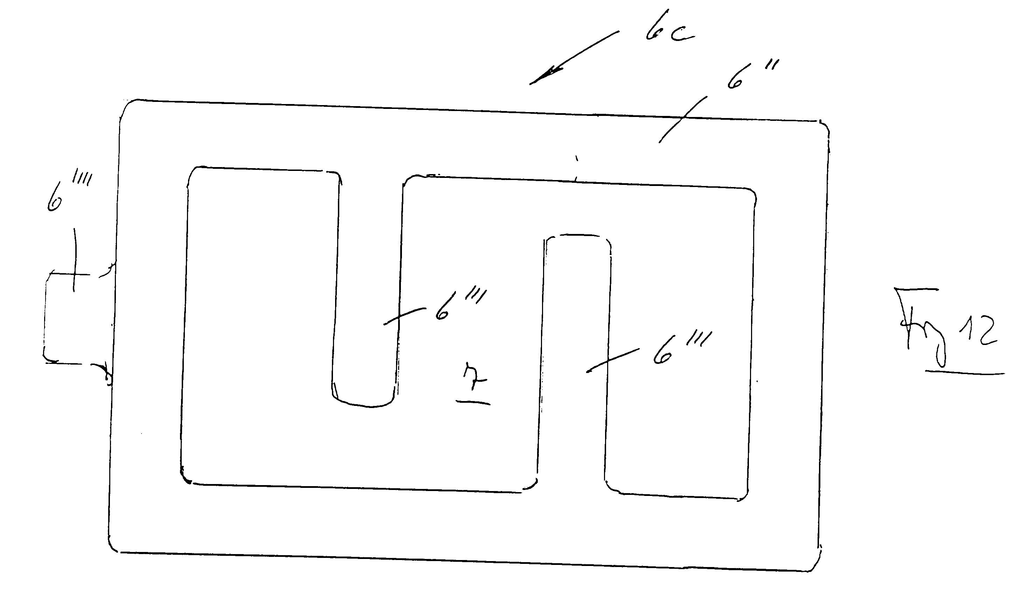

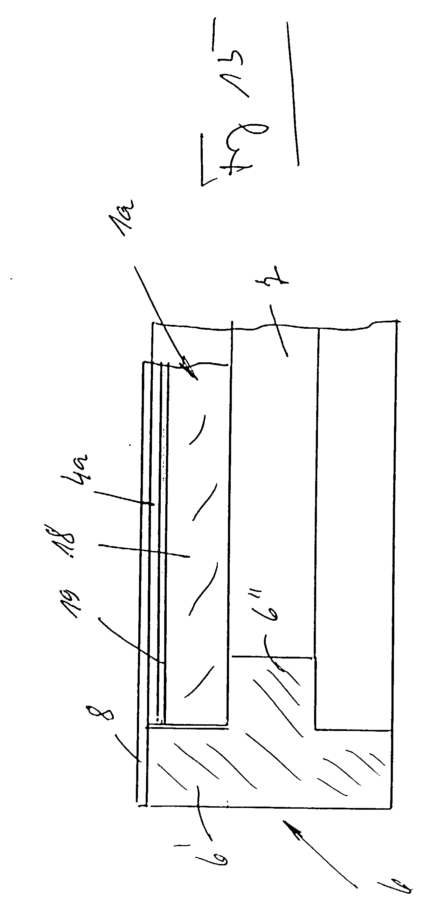

Die Figuren 7 und 8 zeigen als weitere mögliche Ausführungsform ein Fixierelement 6a, welches sich von dem Fixierelement 6 im wesentlichen nur durch eine eingebettete Metalleinlage 10 unterscheidet, die bei der dargestellten Ausführungsform eine im wesentlichen C-förmige Klammer bildet, welche im Bereich des Abschnittes 6'''' offen ist. Durch die Metalleinlage 10 besitzt das ringförmige Fixierelement 6 eine im wesentlichen starre Struktur, die ein einfacheres Handling, insbesondere Verbinden mit den Substraten 1 und 2 ermöglicht. Die Metalleinlage 10 ist von dem Material des Fixierelementes 6a vollständig umschlossen.

Die Figuren 9 und 10 zeigen in Darstellungen ähnlich den Figuren 6 und 7 eine weitere mögliche Ausführungsform, bei der aber anstelle der Metalleinlage 10 eine Verstärkungsplatte 11 aus einem geeigneten Material, beispielsweise aus Metall vorgesehen ist, die sich in der Mittelebene des ringartigen Fixierelementes 6b erstreckt und am Rand zumindest in dem Profilabschnitt 6'' sowie auch in den Profilabschnitten 6''' eingebettet ist. Die Platte 11 ist eine perforierte Platte mit einer Vielzahl von Öffnungen 1 2, die nicht nur das Einbinden der Platte 11 in das elastische Material der Profilabschnitte 6'' und 6''' verbessern, sondern die zugleich auch eine Verbindung zwischen den beiden Seiten der Platte 11 herstellen, so daß bei Verwendung des Fixierelementes 6b zwischen den Substraten 1 und 2 wiederum nur ein einziger, zu evakuierender Raum 7 gebildet ist. Um das Entlüften durch Ziehen an dem Profilabschnitt 6'''' zu ermöglichen, ist die Platte 11 im Bereich dieses Profilabschnittes mit einem Ausschnitt 13 derart versehen, daß dort die Platte 11 mit ihrem Rand nicht im Profilabschnitt 6'' eingebettet ist. Dem Profilabschnitt 6''' gegenüberliegend ist am Profilabschnitt 6'' eine Einkerbung 14 vorgesehen, die das Belüften des Raumes 7 durch Ziehen am Profilabschnitt 6'''' erleichtert.

Die Figuren 11 und 12 zeigen als weitere mögliche Ausführungsform ein Fixierelement 6c, welches im wesentlichen als einfacher, flacher Ring aus dem elastischen Material hergestellt ist, d.h. ohne den Profilabschnitt 6' und nur mit den Profilabschnitten 6'' - 6''''.

Die Figuren 13 und 14 zeigen als weitere Ausführungsform ein Fixierelement 6d, welches im wesentlichen von einer Platte aus dem elastischen, gummiartigen Material hergestellt ist. In dieser Platte sind mehrere durchgehende Öffnungen 15 vorgesehen, die an einer Seite der Platte durch nutenförmige Kanäle 16 verbunden sind. An einer Seite der Platte ist ein den Profilabschnitt 6''''entsprechender Ansatz 17 angeformt, der einer Öffnung 15 benachbart liegt. Bei der dargestellten Ausführungsform erstreckt sich einer der Kanäle 16 bis in die Nähe des Ansatzes 17, endet aber mit einem vorgegebenen Abstand vor diesem Ansatz bzw. der entsprechenden Umfangsseite des Fixierelementes 6d. Im Verwendungsfall wird das plattenförmige Fixierelement 6d zwischen den beiden Substraten 1 und 2 angeordnet. Anschließend erfolgt ein Evakuieren der von den Öffnungen 15 gebildeten Räume zwischen den beiden Substraten 1 und 2. Über die Kanäle 16 sind diese Räume miteinander verbunden. Durch die anliegenden Substrate 1 und 2 sind die von den Öffnungen 15 und den Kanälen 16 gebildeten evakuierten Innenräume zur Atmosphäre hin abgedichtet, so daß die Substrate 1 und 2 durch Unterdruck über das Fixierelement 6d zusammengehalten sind. Nach dem Behandeln können dann durch Ziehen an dem Ansatz 17 die Substrate 1 und 2 von dem Fixierelement 6d gelöst werden.

Bei der bisherigen Beschreibung wurde davon ausgegangen, daß die Substrate 1 und 2 jeweils Metall-Keramik-Substrate sind, und zwar speziell solche, bei denen die Keramikschicht 3 beidseitig mit jeweils einer Metallisierung 4, 5 versehen ist, die in Form einer Metallfolie mit der DCB-Technik oder durch Aktivlöten flächig aufgebracht wurde. Grundsätzlich sind natürlich auch andere Anwendungsfälle denkbar, nämlich beispielsweise Substrate, die nur an einer Seite eine Metallisierung aufweisen, Substrate, deren Metallisierung durch eine andere Technik, beispielsweise durch eine Dickfilmtechnik auf einer oder auf zwei Oberfächenseiten erzeugt ist, usw..

Die Figur 15 zeigt ein Substrat 1a, welches aus einer Tragschicht 18 aus Aluminium besteht, die an einer Oberflächenseite mit einer dünnen Isolierschicht 19 versehen ist, auf der die zu strukturierende Metallisierung 4a aufgebracht ist. Für die Strukturierung ist die Metallisierung 4a wiederum mit dem Fotolack 8 beschichtet, aus dem die Fotolackmaske für die Strukturierung durch das spätere Ätzen gebildet wird. Der Fotolack 8 überdeckt auch bei dieser Ausführung wiederum den Spalt zwischen dem Profilabschnitt 6' und dem Rand des Substrates 1a.

Durch die Anwendung des erfindungsgemäßen Verfahrens, insbesondere durch die Anwendung eines Fixierelementes 6, 6a, 6b mit dem Profilabschnitt 6' und die Überbrückung des Übergangs zwischen den Rand des Substrates 1a und dem Bereich 6' durch die Maske 9 ist ein unerwünschtes Einwirken der Ätzflüssigkeit auf die Trägerschicht 18 beim Ätzen verhindert.

Die Erfindung wurde voranstehend an einem Ausführungsbeispiel beschrieben. Es versteht sich, daß zahlreiche Änderungen sowie Abwandlungen möglich sind, ohne daß dadurh der der Erfindung zugrundeliegende Erfindungsgedanke verlassen wird.

### Bezugszeichenliste

- 1, 2: Substrat
- 3: Keramikschicht
- 4, 5: Metallisierung
- 6, 6a, 6b, 6c, 6d: Fixierelement
- 6', 6'', 6''', 6'''': Profilabschnitt
- 7: Raum
- 8: Fotolackschicht
- 9: Maske
- 10: Metalleinlage
- 11: Versteifungsplatte
- 12: Öffnung
- 13: Ausklinkung
- 14: Einkerbung
- 15: Öffnung
- 16: Kanal
- 17: Ansatz

## Patentansprüche

1. Verfahren zum Herstellen von Substraten (1, 2) mit jeweils wenigstens einer strukturierten Metallisierung (4),
**dadurch gekennzeichnet,** daß zur Strukturierung der Metallisierung von wenigstens zwei Substraten (1, 2) in einem Arbeitsprozeß die beiden Substrate über wenigstens ein Halte- oder Fixiermittel (6, 6a, 6b, 6c, 6d) an einer Oberflächenseiten wieder lösbar und dicht miteinander verbunden werden, und daß in weiteren Verfahrensschritten die Strukturierung der Metallisierungen (4) an den freiliegenden Oberflächenseiten der Substrate (1, 2) erfolgt.

2. Verfahren nach Anspruch 1, dadurch gekennzeichnet, daß die Substrate wenigstens eine Isolierschicht (3) aufweisen, die an einer Seite mit der zu strukturierenden Metallisierung (4) versehen ist, und zwar vorzugsweise in Form einer flächig mit der Isolierschicht verbundenen Metallfolie, wobei die Isolierschicht beispielsweise eine Keramikschicht (3) oder eine Schicht aus einem Kunststoff ist.

3. Verfahren nach Anspruch 1 oder 2, gekennzeichnet durch die Verwendung von Substraten (1, 2) mit einer Metallisierung (4, 5) an einer oder an beiden Oberflächenseiten und/oder
von Substraten mit einer Trägerschicht aus Metall, beispielsweise aus Aluminium besteht, die an wenigstens einer Oberflächenseite mit der von der Trägerschicht durch eine Isolierschicht getrennten Metallisierung (4a) versehen ist.

4. Verfahren nach einem der vorhergehenden Ansprüche, dadurch gekennzeichnet, daß die Substrate (1, 1a, 2) über wenigstens ein Halte- oder Fixierelement (6, 6a, 6b, 6c, 6d) lösbar miteinander verbunden werden,
welches beispielsweise aus einem elastischen, als Dichtung geeigneten Material besteht, das zumindest einen mit einem Unterdruck beaufschlagbaren abgedichteten Raum (7) zwischen den Substraten (1, 1a, 2) bildet und/oder welches zugleich die Substrate (1, 1a, 2) an ihrem Umfang abdeckt.

5. Verfahren nach einem der vorhergehenden Ansprüche, dadurch gekennzeichnet, daß die Substrate (1, 1a, 2) unter Anwendung von Vakuum oder Unterdruck, vorzugsweise unter Verwendung eines Unterdruckes (P), der kleiner ist als 80% des Umgebungsdruckes (Pa), lösbar miteinander verbunden sind.

6. Verfahren nach einem der vorhergehenden Ansprüche, gekennzeichnet durch die Verwendung eines wenigstens Halte- oder Fixierelementes in Form eines zumindest einen abgedichteten Raum (7) zwischen den Substraten bildenden ring-oder plattenartiges Elementes aus elastischen Material, wobei der Raum (7, 15) zwischen den Substraten (1, 1a, 2) evakuiert wird.

7. Verfahren nach einem der vorhergehenden Ansprüche, gekennzeichnet durch die Verwendung eines Fixierelementes, welches eine Vielzahl von vorzugsweise miteinander in Verbindung stehenden Vakuum-Räumen (1 5) aufweist, und/oder
durch die Verwendung eines Fixierelementes, welches wenigstens einen Vakuumraum (7) aufweist, in welchen eine zusätzliche Abstützung für die Substrate bildende Abschnitte (6''') hineinragen;
und/oder
durch die Verwendung eines Halte- und Fixierelementes (6, 6a, 6b, 6c), in dessen Material eine Verstärkung, vorzugsweise eine Verstärkung (10, 11) aus Metall eigebracht ist.

8. Verfahren nach einem der vorhergehenden Ansprüche, dadurch gekennzeichnet, daß die Strukturierung der Metallisierungen (4) an den freiliegenden Oberflächenseiten der Substrate (1, 2) durch Ätzen und unter Verwendung von Ätzmasken erfolgt, wobei beispielsweise aus einem Ätz-Resist gebildete Masken (9) so ausgeführt sind, daß diese auch den Anschlußbereich zwischen einem Rand der Substrate (1, 1a, 2) und einem angrenzenden Halte- oder Fixiermittel oder einem Profilabschnitt (6') eines angrenzenden Fixierelementes (6, 6a, 6b) überbrückt.

9. Verfahren nach einem der vorhergehenden Ansprüche, dadurch gekennzeichnet, daß das Evakuieren des wenigstens einen Raumes zwischen den Substraten (1, 1a, 2) durch Beaufschlagen der von den Substraten und dem Fixierelement gebildeten Anordnung mit einem Unterdruck (P) und vorzugsweise durch anschließendes Belüften auf Atmosphärendruck (Pa) in einer kurzen Zeitperiode erfolgt,
und/oder
daß das Lösen der Substrate (1, 1a, 2) bzw. das Belüften des wenigstens eines Raumes (7) zwischen den Substraten (1, 1a, 2) durch mechanisches Abziehen des Fixierelementes (6, 6a, 6b, 6c, 6d) erfolgt,
und/oder
daß das Lösen der Substrate (1, 1a, 2) von dem Fixierelement durch Beaufschlagen der Anordnung mit dem Unterdruck und durch langsames Belüften erfolgt.

10. Halte- oder Fixierelement zur Verwendung bei dem Verfahren nach einem der Ansprüche 1 - 1 9, gekennzeichnet durch seine Ausbildung als ring- oder plattenartiger Formkörper aus einem abdichtenden Material, beispielsweise aus einem elastischen oder gummiartigen Material, wobei der Formkörper wenigstens eine an ihrem Umfang geschlossene Öffnung (7, 15) und an zwei einander gegenüberliegenden Seiten jeweils eine die Öffnung umschließende Anlagefläche für ein Substrat aufweist.

11. Halte- oder Fixierelement nach Anspruch 12, dadurch gekennzeichnet, daß es mit einem Profilabschnitt (6') einen über die Anlageflächen wegstehenden Rand zur Abdeckung der Substrate (1, 1a, 2) an ihrem Umfang bildet.

12. Halte- oder Fixierelement, gekennzeichnet
durch eine Vielzahl von vorzugsweise miteinander in Verbindung stehenden Öffnungen (15),
und/oder
durch einen über den Ring oder die Platte nach außen wegstehenden, vorzugsweise angeformten Abschnitt (6''') zum teilweisen Abziehen des Halte- oder Fixierelementes (6, 6a, 6b, 6c),
und/oder
durch eine in das Material des Halte- und Fixierelementes (6, 6a, 6b, 6c) eingebrachte Verstärkung, vorzugsweise eine Verstärkung (10, 11) aus Metall.
